# FASCICULE DE BREVET EUROPEEN

(11) **EP 1 397 806 B1**
(45) Date de publication et mention de la délivrance du brevet: **03.08.2005**
(21) Numéro de dépôt: 02730354.4
(22) Date de dépôt: 04.04.2002
(51) Int. Cl.: G11C 5/00, G11C 8/20

(54) **IDENTIFICATION D'UN CIRCUIT INTEGRE A PARTIR DE SES PARAMETRES PHYSIQUES DE FABRICATION**
IDENTIFIKATION EINER INTEGRIERTEN SCHALTUNG AUS IHREN PHYSIKALISCHEN HERSTELLUNGSPARAMETERN
IDENTIFICATION OF AN INTEGRATED CIRCUIT FROM ITS PHYSICAL MANUFACTURE PARAMETERS

(30) Priorité: 04.04.2001 FR 0104585
(43) Date de publication de la demande: 17.03.2004
(73) Titulaire: STMicroelectronics S.A., 92120 Montrouge (FR)
(72) Inventeur: BARDOUILLET, Michel, F-13790 Rousset (FR); WUIDART, Luc, F-83910 Pourrières (FR)
(74) Mandataire: de Beaumont, Michel
(86) Numéro de dépôt international: PCT/FR2002/001192
(87) Numéro de publication internationale: WO 2002/082448

(56) Documents cités:
- EP-A- 1 148 647
- DE-C- 19 510 038
- US-A- 3 911 368
- US-A- 4 023 110
- US-A- 4 675 612
- US-A- 5 204 559
- US-A- 5 608 645
- US-A- 5 686 850

## Description

La présente invention concerne l'identification d'un élément ou ensemble électronique à partir de paramètres liés à la fabrication d'un circuit d'identification contenu dans une puce de circuit intégré. Une telle identification fait généralement appel à un réseau de paramètres physiques (PPN) liés à la fabrication de la puce de circuit intégré. Cette identification est couramment désignée par l'expression anglo-saxonne "integrated circuit fingerprint".

Une première famille de méthodes connues d'identification consiste à mesurer des paramètres électriques de la puce de circuit intégré. Il peut s'agir, par exemple, d'une mesure d'une tension seuil d'un transistor, d'une mesure de résistance ou d'une mesure d'une capacité parasite. Comme ces caractéristiques sont sensibles aux dispersions technologiques et de procédé de fabrication, on peut considérer que le ou les paramètres électriques pris en compte sont propres à une fabrication et constituent une "signature" des circuits intégrés issus de cette fabrication. Un exemple de procédé ayant recours à une mesure de paramètres électriques est décrit dans le brevet américain n° 6 161 213.

Un inconvénient du recours à une mesure de paramètres électriques est que ces grandeurs évoluent dans le temps (dans la vie du circuit). Par conséquent, la signature obtenue n'est pas stable.

Un autre inconvénient est qu'il est nécessaire d'effectuer la différence entre une signature mesurée (par exemple, la tension aux bornes d'une capacité) et une signature prédéfinie. Il est par conséquent nécessaire de disposer d'un convertisseur analogique/numérique pour convertir les signaux mesurés avant d'en effectuer la différence permettant l'identification.

Outre les problèmes de stabilité, le convertisseur doit être très précis en raison des faibles variations que l'on doit mesurer. En effet, il s'agit de dispersions technologiques qui, par nature, sont très faibles (par exemple, pour la tension seuil d'un transistor MOS, la dispersion est généralement de +/- 4 millivolts. Pour une mesure de tension, il peut s'agir de détecter une différence inférieure au millivolt sur une plage de valeur d'environ 200 millivolts. Pour un tel exemple, un convertisseur 12 bits est nécessaire.

Un autre inconvénient est que, pour des questions de fiabilité, il est souvent nécessaire d'examiner plusieurs points du circuit. Cela nécessite par conséquent un multiplexeur analogique, sauf à augmenter le nombre de convertisseurs utilisés.

Une deuxième famille de solutions connues fait appel à une mesure temporelle. Par exemple, on mesure le temps de lecture/écriture d'une mémoire de type EEPROM. Un exemple de procédé d'identification ayant recours à une mesure de temps d'exécution d'opérations est décrit dans le brevet américain n° 5 818 738.

Cette famille de solutions présente les mêmes inconvénients que la précédente. La différence est que le convertisseur est remplacé par un compteur.

Que ce soit dans la première ou dans la deuxième famille de solutions, on a recours à une mesure et on compare la signature obtenue par rapport à une valeur étalon stockée, soit dans le circuit intégré, soit dans un dispositif externe dans le cas d'une authentification par rapport à des éléments distants.

Toutes ces solutions présentent donc l'inconvénient majeur d'être encombrantes et délicates à mettre en oeuvre pour un résultat incertain.

L'invention vise à proposer une nouvelle manière d'effectuer une identification d'un ensemble ou élément électronique à partir de paramètres physiques d'une puce de circuit intégré qu'il contient. L'invention vise, plus particulièrement, à proposer un nouveau procédé d'identification ainsi qu'un nouveau circuit d'identification de type réseau de paramètres physiques qui pallient au moins un des inconvénients des procédés et circuits connus.

L'invention vise également à proposer une solution qui évite le recours à des convertisseurs analogiques-numériques ou à des compteurs.

La présente invention vise également à proposer une solution peu gourmande en surface d'intégration.

L'invention vise également à proposer une solution qui soit particulièrement sensible aux dispersions technologiques et de procédé de fabrication, tout en étant stable dans le temps.

L'invention vise en outre à proposer une solution qui soit compatible avec un traitement interne ou externe du code d'identification obtenu.

Pour atteindre ces objets, la présente invention prévoit un circuit d'identification de type réseau de paramètres physiques contenu dans une puce de circuit intégré, comportant :
une unique borne d'entrée d'application d'un signal de déclenchement d'une identification ;
des bornes de sortie propres à délivrer un code binaire d'identification ;
des premiers chemins électriques reliant individuellement ladite borne d'entrée à chaque borne de sortie, chaque chemin apportant un retard sensible aux dispersions technologiques et/ou de procédé de fabrication du circuit intégré ; et
des moyens de prise en compte simultanée des états binaires présents en sortie des chemins électriques.

Selon un mode de réalisation de la présente invention, chaque chemin électrique est constitué d'un élément retardateur et d'une bascule dont une borne d'entrée est reliée en sortie de l'élément retardateur correspondant et dont une borne de sortie définit une des bornes de sortie du circuit d'identification.

Selon un mode de réalisation de la présente invention, lesdits moyens de prise en compte comprennent un deuxième chemin électrique apportant un retard correspondant approximativement au retard moyen des retards apportés par lesdits premiers chemins, ledit deuxième chemin étant intercalé entre ladite borne d'entrée et une borne de déclenchement de prise en compte desdits états binaires.

Selon un mode de réalisation de la présente invention, les entrées d'horloge des différentes bascules sont toutes reliées à ladite borne de déclenchement.

Selon un mode de réalisation de la présente invention, les chemins électriques sont choisis pour apporter des retards du même ordre de grandeur, malgré les dispersions technologiques.

L'invention prévoit également un procédé d'identification d'une puce de circuit intégré à partir de ces paramètres physiques sensibles aux dispersions technologiques, consistant à comparer une durée de parcours moyen d'un signal numérique par rapport à au moins deux autres chemins électriques du même signal numérique.

Selon un mode de réalisation de la présente invention, on synchronise la prise en compte des comparaisons à partir du signal numérique d'entrée.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente un mode de réalisation d'un circuit d'identification intégré selon la présente invention ; et
les figures 2A et 2B illustrent, sous forme de chronogrammes, le fonctionnement du circuit d'identification de la figure 1, pour deux circuits intégrés différents.

Par souci de clarté, seuls les éléments qui sont nécessaires à la compréhension de l'invention ont été représentés aux figures et seront décrits par la suite. En particulier, la destination et l'exploitation faite du code d'identification obtenu par la mise en oeuvre de l'invention n'ont pas été détaillées et ne font pas l'objet de l'invention. De plus, le déclenchement d'une procédure d'identification au moyen d'un circuit intégré selon l'invention pourra être effectué de façon similaire aux solutions classiques qui ne seront pas détaillées.

Une caractéristique de la présente invention est de faire subir, à un même signal d'entrée (signal logique comprenant au moins un front), plusieurs retards différents provenant de chemins électriques apportant chacun un retard sensible aux dispersions technologiques et/ou de procédé de fabrication.

Une autre caractéristique de l'invention est de ne pas mesurer les effets des dispersions technologiques en terme de différence temporelle mais de prévoir une comparaison directe des retards apportés par les différents chemins par rapport à un retard moyen.

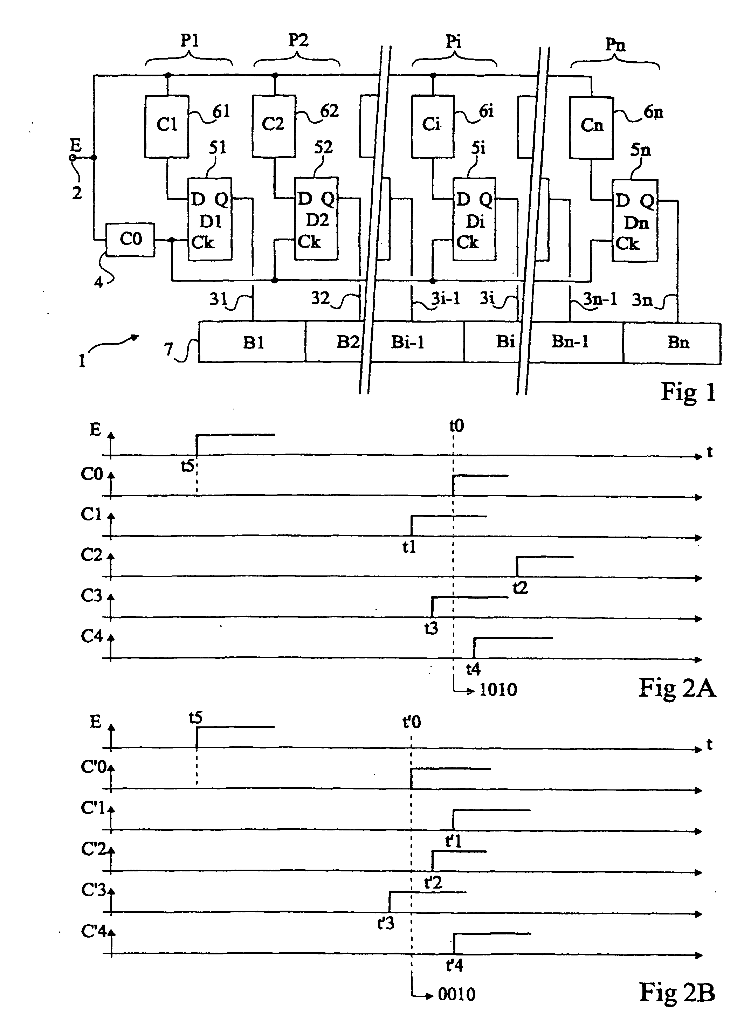

La figure 1 représente le schéma électrique d'un mode de réalisation d'un circuit d'identification intégré selon la présente invention.

Dans cet exemple, le circuit 1 comporte une unique borne 2 d'entrée destinée à recevoir un signal numérique E de déclenchement d'une identification. Pour la mise en oeuvre de l'invention, le signal E doit comprendre, comme on le verra par la suite en relation avec les figures 2A et 2B, au moins un front par identification.

Le rôle du circuit d'identification 1 est de délivrer un code binaire B₁, B₂, ..., Bᵢ₋₁, Bᵢ, ..., Bₙ₋₁, Bₙ sur un nombre de bits prédéterminé, ce code étant sensible aux dispersions technologiques et de procédé de fabrication du circuit. Chaque bit Bᵢ est délivré sur une borne 3₁, 3₂, ..., 3ᵢ₋₁, 3ᵢ, ..., 3ₙ₋₁, 3ₙ du circuit 1 qui lui est propre. Le circuit 1 délivre donc le code d'identification sous forme parallèle.

Selon l'invention, à chaque bit Bᵢ du code d'identification est associé un chemin électrique P₁, P₂, ..., Pᵢ, ..., Pₙ reliant la borne d'entrée commune 2 à une borne 3ᵢ de même rang.

De préférence, les retards apportés par les différents chemins électriques Pᵢ sont choisis pour être légèrement différents les uns des autres de façon à garantir une sensibilité aux dispersions technologiques du procédé de fabrication.

On voit donc déjà que, par les différents retards apportés par les chemins électriques, le front déclencheur du signal d'entrée E est reproduit sur les différentes sorties à des instants différents.

Selon l'invention, on prévoit d'effectuer la lecture de l'information présente aux sorties du circuit 1 de façon synchronisée et à un instant correspondant, de façon approximative, au retard moyen théorique entre les différents chemins électriques.

Plus précisément, selon le mode de réalisation préféré de l'invention illustré par la figure 1, on prévoit un chemin électrique moyen 4 (C0) pour fixer l'instant de lecture à partir de l'apparition du front déclencheur du signal d'entrée E.

Par exemple, le chemin 4 relie l'entrée 2 du circuit 1 aux bornes Ck de bascules 5₁, 5₂, ..., 5ᵢ, ..., 5ₙ faisant partie des chemins électriques respectifs P₁, P₂, ..., Pᵢ, ..., Pₙ et dont les sorties respectives Q constituent les bornes 3₁, 3₂, ..., 3ᵢ, ..., 3ₙ de sortie du circuit 1. Selon ce mode de réalisation, chaque chemin électrique Pᵢ comporte un élément retardateur 6₁ (C1), 6₂ (C2) ..., 6ᵢ (Ci) ..., 6ₙ (Cn) reliant l'entrée 2 du circuit à l'entrée D de la bascule correspondante du chemin. Les éléments retardateurs 6ᵢ sont les éléments qui présentent, selon la présente invention, des retards différents les uns par rapport aux autres. En effet, les bascules 5ᵢ ont, de préférence, la même constitution. Elles participent toutefois au retard apporté au signal d'entrée jusqu'aux bornes de sortie respectives du circuit 1 par rapport au retard moyen C0 apporté par l'élément 4.

Lorsqu'on applique un front sur le signal d'entrée E, ce front arrive sur les entrées D respectives des bascules à des instants différents. La lecture de l'état d'entrée des différentes bascules est synchronisée par le front du signal E retardé, cette fois, par l'élément 4. C'est notamment pour cette raison que l'on choisit préférentiellement un retard C0 correspondant approximativement au retard moyen des différents éléments 6ᵢ.

Dans l'exemple de la figure 1, les différentes sorties 3ᵢ du circuit 1 sont reliées individuellement en entrée d'un registre 7 de mémorisation du code binaire obtenu, chaque bit Bᵢ correspondant à l'une des sorties du circuit. Les détails de connexion et de constitution du registre 7 n'ont pas été représentés et ne font pas l'objet de la présente invention. Une fois le code binaire contenu dans ce registre, son exploitation dépend de l'application, et sa mise en oeuvre est à la portée de l'homme du métier.

Les figures 2A et 2B illustrent, sous forme de chronogrammes et sans respect d'échelle, le fonctionnement d'un circuit d'identification selon l'invention. Les figures 2A et 2B représentent des exemples d'allures du signal E, et des signaux en sortie des différents éléments retardateurs. Dans l'exemple des figures 2A et 2B, on considère le cas d'un code binaire sur quatre bits. Les chronogrammes ont été désignés par les références C0, C1, C2, C3 et C4.

La différence entre les figures 2A et 2B représente la différence entre deux circuits 1 intégrés sur des puces issues de fabrications différentes.

En figure 2A, on suppose qu'à un instant t5, on déclenche un front montant sur le signal E. Ce front apparaît sur les différentes entrées des bascules D (correspondant aux sorties des éléments retardateurs C1, C2, C3 et C4) à des instants respectifs différents t1, t2, t3 et t4. Par ailleurs, l'élément 4 (C0) apporte un retard déclenchant la lecture des données en entrée des bascules à un instant t0. Tous les chemins qui génèrent un retard supérieur au retard C0 fournissent un bit à l'état 0 dans la mesure où le front du signal E ne leur est pas encore parvenu. Tous les chemins qui génèrent un délai inférieur au délai C0 produisent un bit à l'état 1 dans le mesure où le front du signal E arrive sur l'entrée de la bascule correspondante avant l'expiration du délai C0. Dans l'exemple de la figure 2A, à l'instant t0, on fournit le code 1010 comme code d'identification.

La figure 2B illustre le même circuit issu d'un procédé de fabrication différent donnant donc une puce différente. Le code obtenu y est différent. Par exemple, il s'agit du code 0010. En figure 2B, on a fait apparaître arbitrairement un instant t5 identique au cas de la figure 2A. Par contre, les instants t'0, t'1, t'2, t'3 et t'4 auxquels le front du signal E a terminé de parcourir les chemins respectifs C0, C1, C2, C3 et C4 sont différents du cas de la figure 2A.

On remarquera que l'élément retardateur C0 est lui-même sensible aux dispersions technologiques et de procédé de fabrication. Cela n'a cependant pas d'incidence pour la mise en oeuvre de l'invention dans la mesure où ce retard représente un retard moyen et où le code d'identification recherché est arbitraire.

En effet, pour une mise en oeuvre de l'invention à une identification de type réseau de paramètres physiques, ce qui est important, c'est que des circuits intégrés issus d'un même procédé de fabrication fournissent le même code. Comme les éléments retardateurs sont sensibles aux dispersions de procédé de fabrication, ce sera le cas avec la mise en oeuvre de l'invention.

Un avantage de la présente invention est que l'identification est particulièrement précise et fiable. En particulier, en supprimant le recours à une mesure (de tension ou de temps), on s'affranchit des problèmes de précision de convertisseurs ou de compteurs.

Un autre avantage de l'invention est que le circuit d'identification est particulièrement sensible. En pratique, la différence détectable des retards apportés par les différents chemins est de l'ordre de la picoseconde. Or, les dispersions des procédés de fabrication ou technologiques apportent le plus souvent des différences de l'ordre d'au moins une dizaine de picosecondes.

Un autre avantage de la présente invention est qu'en cas de dérive dans le temps d'un des retards apportés par les éléments, cela n'affecte pas les résultats du circuit. En effet, tous les éléments de retard étant de préférence de constitution similaire, la dispersion sera dans le même sens pour tous les éléments (chemins).

Pour réaliser les éléments retardateurs des chemins électriques de l'invention, on pourra utiliser n'importe quels éléments intégrés sensibles aux dispersions technologiques ou influencés par le procédé de fabrication. Il pourra s'agir, par exemple, de séries de résistances et/ou de condensateurs. Pour les résistances, on pourra recourir à des résistances dans l'épaisseur du circuit intégré, mais on préférera utiliser des résistances en silicium polycristallin dont la valeur est liée à la géométrie et qui présentent l'avantage d'être moins dépendante de la température.

Selon l'invention, une phase d'identification est déclenchée par un front du signal d'entrée E. Le nombre de phases dépend de l'application et de la destination du circuit d'identification. S'il s'agit d'une carte à puce, on pourra prévoir, par exemple, une identification à chaque échange effectué entre cette carte et un dispositif externe, même au cours de la même transaction.

Bien entendu, la présente invention est susceptible de diverses variantes et modifications qui apparaîtront à l'homme de l'art. En particulier, la réalisation pratique des éléments retardateurs de l'invention pourra prendre des formes différentes, pourvu d'être sensible aux dispersions techno-logiques et/ou de procédés de fabrication.

De plus, le choix de la plage de variation des retards apportés par les différents éléments dépendent de l'application et de la sensibilité souhaitée. Ce choix est à la portée de l'homme du métier à partir des indications fonctionnelles données ci-dessus.

Par ailleurs, on notera que le nombre de bits du code fournit par le circuit de l'invention dépend également de la sensibilité souhaitée. Plus le nombre de bits est élevé plus le circuit sera sensible à des variations de code.

Enfin, on pourra prévoir différents éléments d'exploitation du code binaire. Celui-ci pourra soit être stocké dans un registre, soit être exploité directement pour valider ou invalider une fonction du circuit dans lequel il est intégré, par exemple, l'alimentation de ce circuit.

## Revendications

1. Circuit (1) d'identification de type réseau de paramètres physiques contenu dans une puce de circuit intégré, **caractérisé en ce qu'**il comporte :
une unique borne (2) d'entrée d'application d'un signal (E) de déclenchement d'une identification ;
des bornes (3₁, 3₂, ..., 3ᵢ₋₁, 3ᵢ, ..., 3ₙ₋₁, 3ₙ) de sortie propres à délivrer un code binaire (B₁, B₂, ..., Bᵢ₋₁, Bᵢ, ..., Bₙ₋₁, Bₙ) d'identification ;
des premiers chemins électriques (P₁, P₂, ..., Pᵢ, ..., Pₙ) reliant individuellement ladite borne d'entrée à chaque borne de sortie, chaque chemin apportant un retard sensible aux dispersions technologiques et/ou de procédé de fabrication du circuit intégré ; et
des moyens (4, 5₁, 5₂, ..., 5ᵢ, ..., 5ₙ) de prise en compte simultanée des états binaires présents en sortie des chemins électriques.

2. Circuit selon la revendication 1, **caractérisé en ce que** chaque chemin électrique (P₁, P₂, ..., Pᵢ, ..., Pₙ) est constitué d'un élément retardateur (6₁, 6₂, ..., 6ᵢ, ..., 6ₙ) et d'une bascule (5₁, 5₂, ..., 5ᵢ, ..., 5ₙ) dont une borne d'entrée (D) est reliée en sortie de l'élément retardateur correspondant et dont une borne de sortie (Q) définit une des bornes de sortie (3₁, 3₂, ..., 3ᵢ₋₁, 3ᵢ, ..., 3ₙ₋₁, 3ₙ) du circuit d'identification.

3. Circuit selon la revendication 1 ou 2, **caractérisé en ce que** lesdits moyens de prise en compte comprennent un deuxième chemin électrique (4) apportant un retard (C0) correspondant approximativement au retard moyen des retards apportés par lesdits premiers chemins (P₁, P₂, ..., Pᵢ, ..., Pₙ), ledit deuxième chemin étant intercalé entre ladite borne d'entrée (2) et une borne de déclenchement de prise en compte desdits états binaires.

4. Circuit selon les revendications 2 et 3, **caractérisé en ce que** les entrées d'horloge (Ck) des différentes bascules (5₁, 5₂, ..., 5ᵢ, ..., 5ₙ) sont toutes reliées à ladite borne de déclenchement.

5. Circuit selon l'une quelconque des revendications 1 à 4, **caractérisé en ce que** les chemins électriques (P₁, P₂, ..., Pᵢ, ..., Pₙ) sont choisis pour apporter des retards du même ordre de grandeur, malgré les dispersions technologiques.

6. Procédé d'identification d'une puce de circuit intégré à partir de ces paramètres physiques sensibles aux dispersions technologiques, **caractérisé en ce qu'**il consiste à comparer une durée de parcours moyen d'un signal numérique par rapport à au moins deux autres chemins électriques du même signal numérique.

7. Procédé selon la revendication 6, **caractérisé en ce qu'**il consiste à synchroniser la prise en compte des comparaisons à partir du signal numérique d'entrée (E).

## Patentansprüche

1. Identifizierungsschaltung (1) vom Typ eines in einem integrierten Schaltungstyp enthaltenen Netzes physikalischer Parameter, **dadurch gekennzeichnet, dass** die Schaltung umfasst:
- einen einzigen Eingangsanschluss (2) zur Eingabe eines Signals (E) für die Auslösung bzw. den Start einer Identifi-zierung;
- Ausgangsanschlüsse (3₁, 3₂, ..., 3ᵢ₋₁, 3ᵢ, ..., 3ₙ₋₁, 3ₙ), die einen Identifizierungs-Binärcode (B₁, B₂, ..., Bᵢ₋₁, Bᵢ, ..., Bₙ₋₁, Bₙ) abzugeben vermögen;
- erste elektrische Pfade (P₁, P₂, ..., Pᵢ, ..., Pₙ), welche jeweils einzeln den genannten Eingangsanschluss mit jedem Ausgangsanschluss verbinden, wobei jeder Pfad jeweils eine für technologische Streuungen bzw. Dispersionen und/oder Disper-sionen des Herstellungsverfahrens der integrierten Schaltung empfindliche bzw. ansprechende Verzögerung einführt; sowie
- Mittel (4, 5₁, 5₂, ..., 5ᵢ, ..., 5ₙ) zur gleichzeitigen Feststellung bzw. Berücksichtigung der im Ausgang der elek-trischen Pfade vorliegenden Binärzustände.

2. Schaltung nach Anspruch 1, **dadurch gekennzeichnet, dass** jeweils jeder elektrische Pfad (P₁, P₂, ..., Pᵢ, ..., Pₙ) aus einem Verzögerungselement (6₁, 6₂, ..., 6ᵢ, ..., 6ₙ) und einer Kippschaltung (5₁, 5₂, ..., 5ᵢ, ..., 5ₙ) besteht, von welcher jeweils ein Eingangsanschluss (D) mit einem Ausgang des entsprechenden Verzögerungselements verbunden ist und jeweils ein Ausgangsanschluss (Q) einen der Ausgangsanschlüsse (3₁, 3₂, ..., 3ᵢ₋₁, 3ᵢ, ..., 3ₙ₋₁, 3ₙ) der Identifizierungs-schaltung definiert.

3. Schaltung nach Anspruch 1 oder 2, **dadurch gekennzeichnet, dass** die Mittel zur Feststellung bzw. Berücksichtigung einen zweiten elektrischen Pfad (4) umfassen, welcher eine Verzögerung (C0) einführt, die annähernd der mittleren Verzögerung der durch die genannten ersten Pfade (P₁, P₂, ..., Pᵢ, ..., Pₙ) eingeführten Verzögerungen entspricht, wobei der genannte zweite Pfad zwischen dem genannten Eingangsanschluss (2) und einem Anschluss zur Auslösung bzw. zum Start der Feststellung bzw. Berücksichtigung der genannten Binärzustände zwischengeschaltet ist.

4. Schaltung nach den Ansprüchen 2 und 3, **dadurch gekennzeichnet, dass** die Takteingänge (Ck) der verschiedenen Kippschaltungen (5₁, 5₂, ..., 5ᵢ, ..., 5ₙ) sämtlich mit dem genannten Auslöse- bzw. Startanschluss verbunden sind.

5. Schaltung nach einem der Ansprüche 1 bis 4, **dadurch gekennzeichnet, dass** die elektrischen Pfade (P₁, P₂, ..., Pᵢ, ..., Pₙ) so gewählt sind, dass sie Verzögerungen der gleichen Größenordnung trotz der technologischen Streuabweichungen bzw. Dispersionen einführen.

6. Verfahren zum Identifizieren eines integrierten Schaltungschips ausgehend von bzw. auf der Grundlage dieser für die technologischen Streudispersionen empfindlichen physikalischen Parameter, **dadurch gekennzeichnet, dass** das Verfahren im Vergleich einer mittleren Laufdauer eines digitalen Signals relativ bezüglich wenigstens zwei anderen elektrischen Pfaden desselben digitalen Signals besteht.

7. Verfahren nach Anspruch 6, **dadurch gekennzeichnet, dass** es die Synchronisierung der Feststellung bzw. Berücksichtigung der Vergleichswerte ausgehend von dem digitalen Eingangssignal (E) umfasst.

## Claims

1. A network-type identification circuit (1) of physical parameters, contained in an integrated circuit chip, **characterized in that** it comprises:
a single input terminal (2) of application of a signal (E) for triggering an identification;
output terminals (3₁, 3₂, ..., 3ᵢ₋₁, 3ᵢ, ..., 3ₙ₋₁, 3ₙ) adapted to providing a binary identification code (B₁, B₂, ..., Bᵢ₋₁, Bᵢ, ..., Bₙ₋₁, Bₙ);
first electric paths (P₁, P₂, ..., Pᵢ, ..., Pₙ) individually connecting said input terminal to each output terminal, each path introducing a delay sensitive to technological and/or manufacturing process dispersions of the integrated circuit; and
means (4, 5₁, 5₂, ..., 5ᵢ, ..., 5ₙ) for simultaneously taking into account binary states present at the outputs of the electric paths.

2. The circuit of claim 1, **characterized in that** each electric path (P₁, P₂, ..., Pᵢ, ..., Pₙ) is formed of a delay element (6₁, 6₂, ..., 6ᵢ, ..., 6ₙ) and of a flip-flop (5₁, 5₂, ..., 5ᵢ, ..., 5ₙ) having an input terminal (D) connected at the output of the corresponding delay element and having an output terminal (Q) defining one of the output terminals (3₁, 3₂, ..., 3ᵢ₋₁, 3ᵢ, ..., 3ₙ₋₁, 3ₙ) of the identification circuit.

3. The circuit of claim 1 or 2, **characterized in that** said means for taking into account comprise a second electric path (4) introducing a delay (C0) approximately corresponding to the average delay of the delays introduced by said first paths (P₁, P₂, ..., Pᵢ, ..., Pₙ), said second path being interposed between said input terminal (2) and a terminal for triggering the taking into account of said binary states.

4. The circuit of claims 2 and 3, **characterized in that** clock inputs (Ck) of the different flip-flops (5₁, 5₂, ..., 5ᵢ, ..., 5ₙ) are all connected to said triggering terminal.

5. The circuit of any of claims 1 to 4, **characterized in that** the electric paths (P₁, P₂, ..., Pᵢ, ..., Pₙ) are chosen to introduce delays of the same order of magnitude, despite technological dispersions.

6. A method for identifying an integrated circuit chip based on these physical parameters sensitive to technological dispersions, **characterized in that** it consists of comparing an average travel duration of a digital signal with respect to at least two other electric paths of the same digital signal.

7. The method of claim 6, **characterized in that** the taking into account of the comparisons is synchronized on the basis of the digital input signal (E).
